(19) Europäisches Patentamt
European Patent Office
Office européen des brevets

(11) **EP 4 503 103 A1**

(12) **EUROPEAN PATENT APPLICATION**
published in accordance with Art. 153(4) EPC

(43) Date of publication:
**05.02.2025 Bulletin 2025/06**

(21) Application number: **23780459.6**

(22) Date of filing: **28.03.2023**

(51) International Patent Classification (IPC):
*H01L 21/52* (2006.01)    *B22F 1/00* (2022.01)
*B22F 7/08* (2006.01)

(52) Cooperative Patent Classification (CPC):
**B22F 1/00; B22F 7/08; H01L 21/52**

(86) International application number:
**PCT/JP2023/012388**

(87) International publication number:
**WO 2023/190450 (05.10.2023 Gazette 2023/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **30.03.2022  JP 2022056554**

(71) Applicant: **Mitsui Mining & Smelting Co., Ltd.
Shinagawa-ku
Tokyo 141-8584 (JP)**

(72) Inventors:
• **HATTORI, Takashi
Ageo-shi, Saitama 362-0021 (JP)**
• **YAMAUCHI, Shinichi
Ageo-shi, Saitama 362-0021 (JP)**
• **ANAI, Kei
Ageo-shi, Saitama 362-0021 (JP)**

(74) Representative: **Novagraaf Technologies
Bâtiment O2
2, rue Sarah Bernhardt
CS90017
92665 Asnières-sur-Seine Cedex (FR)**

(54) **BONDED BODY MANUFACTURING METHOD**

(57)    A method for producing a joined body includes: forming a coating film between a joining target member and a second joining target member, wherein the coating film is formed from a paste containing copper particles, and then heating the coating film to sinter the copper particles to form a joining layer; wherein the copper particles have an average primary particle size of 0.06 $\mu$m or more and 1.0 $\mu$m or less, and include copper particles having an increase rate of the crystallite size, $(D2 - D1)/D1 \times 100$, of 5% or more, where D1 represents the crystallite size (nm) at 150°C and D2 represents the crystallite size (nm) at 250°C; and the coating film is held at a heating temperature of 150°C or more and 350°C or less for 45 minutes or less to sinter the copper particles.

Fig. 1

EP 4 503 103 A1

## Description

### Technical Field

The present invention relates to a method for producing a joined body.

### Background Art

In recent years, semiconductor devices such as an IGBT have been used, in which a large electric current passes to generate a large amount of heat, and a method for producing such semiconductor devices includes a step of joining target members to be joined (hereinafter, the "target member to be joined" will also be referred to as "joining target member" or simply "target member"), such as a semiconductor element and a circuit substrate, with a material for joining (hereinafter, also referred to as "joining material") that contains sinterable metal particles.

For example, Patent Literature 1 discloses copper particles used as a material for joining target members at a low temperature, wherein the copper particles satisfy the following relationships between crystallite sizes and temperatures while the copper particles are heated in an inert atmosphere: (a) when the ratio of the copper crystallite size at a given temperature to that at 30°C reaches 1.2, the given temperature is 250°C or less, and (b) the change in the above-described ratio is $2.0 \times 10^{-3}$ or more, per unit temperature, in a temperature range of 250°C or more and 350°C or less.

### Citation List

Patent Literature

Patent Literature 1: JP 2019-2054A

### Summary of Invention

It can be said that the copper particles disclosed in Patent Literature 1 are excellent in terms of sinterability. However, the copper particles tend to develop a large volume contraction, and thus when a joined body is obtained by sintering a paste containing the copper particles, cracks due to contraction are likely to be formed in a resulting joining layer, disadvantageously. Also, when the joining layer is viewed in a plan view, the cracks due to contraction are visible in an end portion (hereinafter, also referred to as a "fillet portion") of the joining layer, on which portion the semiconductor element is not placed, and as a result, the joining strength between the fillet portion of the joining layer and the substrate (joining target member) is not sufficiently exhibited, so that the end portion of the joining layer unfortunately separates from the substrate.

Accordingly, it is an object of the present invention to provide a method for producing a joined body, wherein in the joined body to be obtained, the fillet portion of the joining layer is less likely to separate from the joining target member.

The inventors have conducted in-depth studies to solve the problems described above. As a result, they have found that the fillet portion of the joining layer is less likely to separate from the joining target member when copper particles having a specific particle size and a specific crystallite size as sinterable metal particles are employed and sintered in a specific sintering temperature condition.

Specifically, the present invention provides a method for producing a joined body, the method including: forming a coating film between first and second target members to be joined, wherein the coating film is formed from a paste containing copper particles, and then heating the coating film to sinter the copper particles to form a joining layer; wherein the copper particles have an average primary particle size of 0.06 $\mu$m or more and 1 $\mu$m or less, and include copper particles having an increase rate of a crystallite size, (D2 - D1)/D1 $\times$ 100, of 5% or more, where D1 represents a crystallite size (nm) at 150°C and D2 represents a crystallite size (nm) at 250°C; and the coating film is held at a heating temperature of 150°C or more and 350°C or less for 45 minutes or less to sinter the copper particles.

### Brief Description of Drawings

[Fig. 1] Fig. 1 is a schematic diagram showing the steps of the method for producing a joined body according to the present invention.

[Fig. 2] Fig. 2 is a cross-sectional view of a joined body obtained by the production method according to the present invention.

**Description of Embodiments**

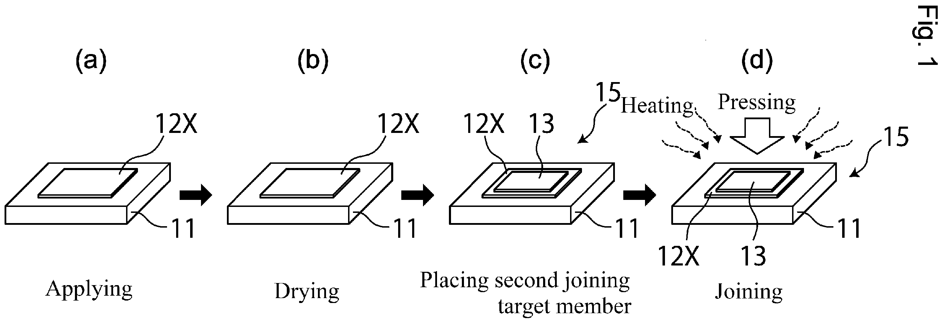

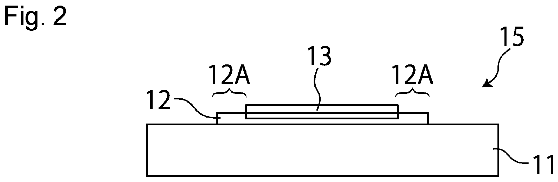

Hereinafter, the present invention will be described by way of preferred embodiments thereof. Fig. 1 is a process diagram illustrating the joining method for a joined body according to the present invention, and Fig. 2 is a cross-sectional view of a joined body obtained by the production method shown in Fig. 1.

First, as shown in Fig. 1(a), a paste containing copper particles is applied to a first joining target member 11 to form a coating film 12X. There is no particular limitation on the method for applying the paste, and examples thereof include, screen printing, dispense printing, gravure printing, and offset printing.

The paste used in the present invention contains copper particles, and an organic solvent, a modifier, and others, which will be described later, as appropriate.

The copper particles have an average primary particle size of preferably 0.06 $\mu$m or more, more preferably 0.08 $\mu$m or more, and even more preferably 0.1 $\mu$m or more. On the other hand, the copper particles have an average primary particle size of preferably 1 $\mu$m or less, more preferably 0.8 $\mu$m or less, even more preferably 0.5 $\mu$m or less, and yet even more preferably 0.3 $\mu$m or less. When the copper particles have an average primary particle size of 0.06 $\mu$m or more, it is possible to prevent formation of cracks in the joining layer during the process including forming the paste containing the copper particles into a coating film and sintering the coating film to form a joining layer, thereby to obtain a satisfactory joining strength between joining target members (the first joining target member and the second joining target member), and also to obtain an increased joining strength between the fillet portion of the joining layer and the first joining target member. On the other hand, when the copper particles have an average primary particle size of 1 $\mu$m or less, the increase rate of the crystallite size, (D2 - D1)/D1 $\times$ 100, which will be described below, can be easily adjusted within a preferred range.

The copper particles have an increase rate of the crystallite size, (D2 - D1)/D1 $\times$ 100, of 5% or more, preferably 6% or more, more preferably 7.5% or more, and even more preferably 8% or more, where D1 represents the crystallite size (nm) at 150°C and D2 represents the crystallite size (nm) at 250°C. The increase rate (D2 - D1)/D1 $\times$ 100 is used as a measure of sinterability of the copper particles. Owing to a synergistic effect of the increase rate of the crystallite size within the above-described range and the average primary particle size within the above-described range, the joined body obtained by the production method of the present invention has a satisfactory joining strength between joining target members (the first joining target member and the second joining target member) and also, the fillet portion of the joining layer does not separate from the first joining target member. Hereinafter, the increase rate of the crystallite size will be also referred to as "crystallite size increase rate", and this term means a value calculated from "(D2-D1)/D1$\times$100". There is no particular limitation on the upper limit value of the crystallite size increase rate, and the upper limit value can be about 100%.

No special production method is required to obtain the copper particles having a crystallite size increase rate of 5% or more, and the crystallite size increase rate can be controlled by the type of copper source, the types of an organic surface treatment agent, an reducing agent, an organic solvent, and others used to produce the copper particles, as well as by the reaction time and the reaction temperature in production of the copper particles. Alternatively, copper particles having a crystallite size increase rate of 5% or more may be selected as appropriate from widely available copper particles, and used.

When the copper particles have a crystallite size increase rate of 5% or more and an average primary particle size within the above-described range, the copper particles are favorably sintered; in addition, it is possible to prevent an excessive volume contraction of the copper particles, and accordingly, cracks due to contraction are not formed during the process of sintering the coating film 12X to form the joining layer, so that joining between the first and second joining target members proceeds sufficiently. Moreover, a satisfactory joining strength between the fillet portion of the joining layer and the first joining target member can be obtained.

The proportion of the copper particles that have a crystallite size increase rate of 5% or more is preferably 10 mass% or more, and more preferably 15 mass% or more, in the total amount of the copper particles.

The term "average primary particle size" as used herein refers to a cumulative volume-based particle size at 50% cumulative volume as determined in the following manner. Observation images of the copper particles are obtained under a scanning electron microscope at a magnification within a range of 10,000x or more and 150,000x or less; in the observation images, 50 or more copper particles with clear outlines are selected at random; the particle size (Haywood diameter) of each particle is measured; from the found particle size, the volume of the particle is calculated, assuming that the particles is a true sphere; and the volume-based particle size at 50% cumulative volume is used as the average primary particle size.

The crystallite size of the copper particles in the present invention is determined by analyzing an X-ray diffraction pattern obtained through XRD based on the high-temperature XRD (X-ray powder diffractometry), and then performing calculation using the Scherrer equation.

The high-temperature XRD refers to a method in which a sample is placed in a high-temperature unit capable of heating the sample and is analyzed by XRD while gradually heating the sample. The XRD is performed by using a fully automated horizontal multipurpose X-ray diffractometer manufactured by Rigaku Corporation and, as a detector, a high-speed two-dimensional X-ray detector PILATUS100K/R manufactured by Rigaku Corporation. The conditions for obtaining the X-ray diffraction pattern are as follows.

Optical system: parallel beam
X-ray source: CuK$\alpha$ radiation
Measurement mode: Still mode $2\theta = 42°$ fixed (X-ray diffraction intensity corresponding to $2\theta = 38$ to $48°$ is obtained by the above two-dimensional detector)
Exposure time: 60 seconds
Collimator: $\Phi$ 0.2 mm
Measurement atmosphere: nitrogen
Measurement temperature: 150 and 250°C
Temperature increase rate: 10°C/min
During XRD (exposure time: 60 seconds) at each measurement temperature, the measurement temperature is maintained without temperature increase.

Next, the crystallite size is calculated, using the Scherrer equation below, from the half width of an X-ray diffraction pattern of the crystal plane (111) of copper particles obtained by the above-described XRD.

$$\text{Scherrer equation: } D = K\lambda/\beta\cos\theta$$

D: Crystallite size
K: Scherrer constant (0.94)
$\lambda$: Wavelength of X-ray
$\beta$: Half width [rad]
$\theta$: Bragg angle [rad]

There is no particular limitation on the shape and the form of the copper particles. For example, the shape of the copper particles may be a spherical shape, a polyhedral shape, a flat shape, an amorphous shape, or any combination thereof. Out of these, a spherical shape, a flat shape, or a combination thereof is preferable. The copper particles may be in the form of a powder, or in the form of a paste or a slurry in which the copper particles are dispersed in an organic solvent.
The copper particles may have a surface treatment agent applied to the surfaces thereof. The surface treatment agent applied to the surfaces of the copper particles can suppress excessive aggregation of the copper particles.
Examples of the surface treatment agent include, but not particularly limited to, a fatty acid, an aliphatic amine, and a complex that can be adsorbed to copper.
The viscosity of the paste can be measured using a rheometer MARS III manufactured by Thermo Scientific, Inc. In view of enhancing the ease of application and printing of the paste, the viscosity of the paste is preferably 10 Pa•s or more and 200 Pa•s or less, more preferably 15 Pa•s or more and 200 Pa•s or less, and even more preferably 30 Pa•s or more and 90 Pa•s or less, as measured at a shear rate of 10 s$^{-1}$. The conditions for measuring the viscosity of the paste are as follows.

Measurement mode: shear rate dependent measurement
Sensor: parallel type ($\Phi$ 20 mm)
Measurement temperature: 25°C
Gap: 0.300 mm
Shear rate: 0.05 to 120.01 s$^{-1}$
Measurement time: 2 minutes

In view of ensuring a sufficient thickness of a joining layer, which will be described later, to obtain a sufficient joining strength between the joining layer and the joining target member, the coating film 12X has a thickness of preferably 1 $\mu$m or more, more preferably 5 $\mu$m or more, and even more preferably 10 $\mu$m or more. On the other hand, the coating film 12X has a thickness of preferably 500 $\mu$m or less, and more preferably 300 $\mu$m or less, in view of preventing formation of cracks in the joining layer during the process including sintering the coating film 12X to form the joining layer, which otherwise reduces the joining strength between the joining target members (the first joining target member and the second joining target member), and also in view of preventing the fillet portion of the joining layer from separating from the first joining target member.
In view of enhancing the ease of application of the paste to the joining target member and the shape retention of the coating film 12X, the content of the copper particles in the paste is preferably 60 mass% or more and 99 mass% or less, more preferably 65 mass% or more and 95 mass%, and even more preferably 70 mass% or more and 93 mass% or less.

Examples of the organic solvent include a monohydric alcohol, a polyhydric alcohol, a polyhydric alcohol alkyl ether, a polyhydric alcohol aryl ether, an ester, a nitrogen-containing heterocyclic compound, an amide, an amine, and a saturated hydrocarbon. These organic solvents may be used singly or in a combination of two or more.

As described above, the paste may contain modifiers for modifying various characteristics as appropriate. Examples of the modifier include a reducing agent, a viscosity modifier, and a surface tension modifier.

As the reducing agent, those that promote sintering of the copper particles are preferable, and examples thereof include a monohydric alcohol, a polyhydric alcohol, an amino alcohol, citric acid, oxalic acid, formic acid, ascorbic acid, aldehyde, hydrazine and derivatives thereof, hydroxylamine and derivatives thereof, dithiothreitol, phosphite, hydrophosphite, and phosphorous acid and derivatives thereof.

As the viscosity modifier, those that can adjust the viscosity level of the paste, desirably so as to fall within the above-described range, are preferable, and examples thereof include a ketone, an ester, an alcohol, a glycol, a hydrocarbon, and a polymer.

The surface tension modifier is not limited as long as it can adjust the surface tension of the coating film 12X. Examples thereof include polymers such as an acrylic surfactant, a silicone-based surfactant, an alkyl polyoxyethylene ether, and a fatty acid glycerol ester, and also monomers such as an alcohol-based surfactant, a hydrocarbon-based surfactant, an ester-based surfactant, and glycol.

Next, as shown in Fig. 1(b), the coating film 12X is dried at a temperature less than the sintering temperature of the copper particles contained in the coating film 12X. It is necessary that the drying temperature should be a temperature at which the organic solvent, the modifier, and others contained in the coating film 12X are evaporated, and also that the copper particles should not be sintered, as described above. Accordingly, the drying temperature is preferably 50°C or more and 160°C or less, and more preferably 60°C or more and 150°C or less, provided that the drying temperature is lower than the sintering temperature, which will be described later.

Not all of the organic solvent needs to be removed. It is sufficient that the coating film 12X loses flowability as the result of the removal of the organic solvent. Accordingly, the organic solvent may remain in the coating film 12X in an amount of, for example, 50 mass% or less, and preferably 30 mass% or less.

The coating film 12X can be dried in an inert atmosphere or in the air. The coating film 12X may be dried under reduced pressure. The drying time can be such that the organic solvent, the modifier, and others contained in the coating film 12X are evaporated so as to allow the coating film 12X to lose flowability as the result of the removal of the organic solvent, as described above.

Next, as shown in Fig. 1(c), the second joining target member 13 is placed on the dried the coating film 12X to form a stack 15.

There is no particular limitation on the type of the first joining target member 11 and the second joining target member 13. In general, the first joining target member 11 and the second joining target member 13 each preferably contain a metal in the surface thereof to be joined. For example, at least one of the first joining target member 11 and the second joining target member 13 may be a member having a surface made of a metal. As used herein, the term "metal" used in refers to a metal as such, which is not combined with another element and therefore does not form a compound, or an alloy made of two or more metals. Examples of such metal include copper, silver, gold, aluminum, palladium, nickel, and an alloy of a combination of two or more thereof.

At least one of the first joining target member 11 and the second joining target member 13 may be a dried product formed from a paste containing metal fine particles and an organic solvent. Specifically, a member having a surface made of a metal may be used as the first joining target member 11, while a dried product formed from a paste containing metal fine particles and an organic solvent may be used as the second joining target member 13. In the case where the dried product formed from a paste is used, the dried product is preferably obtained by applying the paste to a support member made of metal such as copper and drying the paste.

Specific examples of the first joining target member 11 and the second joining target member 13 include a spacer and a heat dissipation plate made of any of the above-listed metals, a semiconductor element, and a substrate containing at least one of the above-listed metals in its surface. Examples of the substrate include an insulating substrate having a ceramic or aluminum nitride plate and a metal layer thereon, the layer made of a metal such as copper. In the case where a semiconductor element is used as a joining target member, the semiconductor element contains one or more of elements selected from the group consisting of Si, Ga, Ge, C, N, and As, for example. The first joining target member 11 is preferably a substrate. The second joining target member 13 is preferably a spacer, a heat dissipation plate, or a semiconductor element.

In the case where at least one of the first joining target member 11 and the second joining target member 13 is a member having a surface made of a metal, the surface may be made of one metal or two or more metals. In the case where the surface is made of two or more metals, the surface may be made of an alloy. In general, the surface made of a metal is preferably a flat surface, but may be curved if necessary.

Next, as shown in Fig. 1(d), the stack 15 is held between predetermined jigs (not shown), and then, the stack 15, or in other words, the coating film 12X is heated under pressure at a temperature of 150°C or more and 350°C or less, preferably 170°C or more and 330°C or less, and more preferably 190°C or more and 310°C or less. The heating temperature is maintained preferably for 45 minutes or less, more preferably for 1 minute or more and 40 minutes or less, even more preferably for 2 minutes or more and 35 minutes or less, and yet even more preferably for 2 minutes or more and 20 minutes or less, thereby sintering the copper particles to form a joining layer 12. Maintaining the heating temperature within the above-described range for 45 minutes or less enables prevention of damage to the joining target members by heat and also improvement in the productivity.

According to the production method of the present invention, the joining strength between the joining layer 12 and the first joining target member 11 is large. Accordingly, a fillet portion 12A of the joining layer 12, on which the second joining target member 13 is not placed as shown in Fig. 2, does not separate from the first joining target member 11. As a result, in the resulting the stack 15, the joining layer 12 is joined not only to the second joining target member 13 but also to the first joining target member 11 at a high joining strength, and thus, the joining layer 12 does not separate therefrom.

In Fig. 1, the first joining target member 11 and the second joining target member 13 are joined together by the joining layer 12 while the stack 15 is pressed using jigs. However, the first joining target member 11 and the second joining target member 13 may be joined together by the joining layer 12 without pressing the stack 15. In this case as well, the fillet portion 12A of the joining layer 12 does not separate from the first joining target member 11. As a result, in the resulting stack 15, the joining layer 12 is joined not only to the second joining target member 13 but also to the first joining target member 11 at a high joining strength, and thus, the joining layer 12 does not separate therefrom.

In the case where the first joining target member 11 and the second joining target member 13 are joined together while pressing the stack 15 as described above, it is preferable to press the stack 15 at a pressure of 0.1 MPa or more and 40 MPa or less, in view of sufficiently joining the first joining target member 11 and the second joining target member 13 together by the joining layer 12.

The joined body obtained by the production method of the present invention is preferably used in, for example, an in-vehicle electronic circuit, or an electronic circuit on which a power device is mounted, by taking advantage of improved joining characteristics between the joining target member and the fillet portion of the joining layer.

**Examples**

Hereinafter, the present invention will be described in further detail by way of Examples. However, the scope of the present invention is not limited to Examples given below. Unless otherwise stated, the percent sign "%" used herein means "mass%".

Example 1

(1) Preparation of Joining Paste

Copper particles (CH-0200L1, manufactured by Mitsui Mining & Smelting Co. Ltd.; spherical copper particles with an average primary particle size of 0.16 $\mu$m) and terpineol as an organic solvent were stirred together using a planetary centrifugal mixer. The obtained mixture was kneaded using a three-roll mill (final gap: 10 $\mu$m) to obtain a joining paste. In the joining paste, the proportion of the copper particles was 82%, and the proportion of terpineol was 18%. The viscosity of the joining paste was 44 Pa•s.

The copper particles had a crystallite size increase rate from crystallite size D1 (nm) at 150°C to crystallite size D2 (nm) at 250°C of 8.9%.

(2) Application of Joining Paste to First Joining Target Member

A copper plate with a length of 20 mm, a width of 20 mm, and a thickness of 2 mm was provided, and the joining paste was applied onto the center portion of the copper plate by printing via a metal mask with a length of 10 mm, a width of 10 mm, and a thickness of 100 $\mu$m to form a rectangular coating film. The resulting coating film was dried at 90°C in an air atmosphere for 20 minutes to remove the organic solvent.

(3) Placement of Second Joining Target Member on Dried Coating Film (Formation of Stack)

An Ag-plated alumina chip (length 5.1 mm, width 5.1 mm, thickness 0.5 mm) was provided as the second joining target member that was a model member of a semiconductor power device. Next, the alumina chip was placed on the center of the dried coating film to form a stack in which the first joining target member, the coating film, and the second joining target member were stacked in this order.

(4) Sintering of Stack (Production of Joined Body)

Next, the stack was heated to 250°C in a nitrogen atmosphere, and at the same time, a pressure of 9 MPa was applied so as to act between the first joining target member and the second joining target member in the stack, to produce a joined body. Here, the temperature holding time and the pressure holding time were 5 minutes. The temperature increase rate was 14°C/sec, and the pressure increase rate was 0.6 MPa/sec.

Example 2

A joining paste and a joined body were produced in the same manner as in Example 1, except that the copper particles used in the step (1) were changed to different copper particles (CH-0200L1, manufactured by Mitsui Mining & Smelting Co., Ltd.; spherical copper particles with an average primary particle size of 0.14 μm). The crystallite size increase rate from crystallite size D1 (nm) at 150°C to crystallite size D2 (nm) at 250°C was 8.6%. The viscosity of the joining paste was 70 Pa•s.

Example 3

A joining paste and a joined body were produced in the same manner as in Example 1, except that the copper particles used in the step (1) were changed to different copper particles (CH-0200, available from Mitsui Mining & Smelting Co., Ltd.; spherical copper particles with an average primary particle size of 0.17 μm). The crystallite size increase rate from crystallite size D1 (nm) at 150°C to crystallite size D2 (nm) at 250°C was 6.4%. The viscosity of the joining paste was 42 Pa•s.

Comparative Example 1

A joining paste and a joined body were produced in the same manner as in Example 1, except that the copper particles used in the step (1) were changed to different copper particles (spherical copper particles with an average primary particle size of 0.76 μm). The crystallite size increase rate from crystallite size D1 (nm) at 150°C to crystallite size D2 (nm) at 250°C was 4.4%. The viscosity of the joining paste was 35 Pa•s.

Comparative Example 2

A joining paste and a joined body were produced in the same manner as in Example 1, except that the copper particles used in the step (1) were changed to copper particles (spherical copper particles with an average primary particle size of 0.05 μm). The crystallite size increase rate from crystallite size D1 (nm) at 150°C to crystallite size D2 (nm) at 250°C was 53.7%. The viscosity of the joining paste was 61 Pa•s.

Evaluation of Separation of Fillet Portion of Joining Layer

In order to evaluate separation of the fillet portion of the joining layer, a pseudo joined body sample, which did not have the second joining target member, was produced. Specifically, the dried coating film produced in the step (2) was heated to 250°C in a nitrogen atmosphere without the step (3), to thereby obtain a sample. The temperature holding time was 5 minutes, and the temperature increase rate was 14°C/sec. The sample had the same structure as the exposed portion of the joining layer protruding from the edge of the alumina chip of the joined body produced in the step (4).

The evaluation of separation of the joining layer was performed by a peeling test involving use of a tape. Specifically, adhesive tape (CELLOTAPE (registered trademark) No. 405, manufactured by Nichiban Co., Ltd.) was attached to the sample to cover the joining layer of the sample. Then, a copper plate with a length of 20 mm, a width of 20 mm, and a thickness of 2 mm was placed thereon, and a load of 1.2 kg (including the mass of the copper plate) was applied from above for 20 seconds. After that, the application of the load was terminated, and the copper plate was removed therefrom. The adhesive tape covering the coating film was peeled off in a 180° direction at a speed of 0.1 to 1 mm/sec. The mass of the joining layer attached to the adhesive tape was measured. It is considered that, as the mass of the joining layer attached to the adhesive tape is smaller, it is less likely that the unpressed portion of the joining layer separates. The evaluation results of the samples of Examples and Comparative Examples are shown in Table 1.

In the table, "< 0.1 mg" indicates that the mass of the joining layer attached to the adhesive tape was less than 0.1 mg.

EP 4 503 103 A1

[Table 1]

| | Copper particles | | Separation of fillet portion of joining layer (mg) |
|---|---|---|---|
| | Average primary particle size (μm) | Crystallite size increase rate (D2 - D1)/D1 (%) | |
| Example 1 | 0.16 | 8.9 | < 0.1 |
| Example 2 | 0.14 | 8.6 | < 0.1 |
| Example 3 | 0.17 | 6.4 | 0.70 |
| Comparative Example 1 | 0.76 | 4.4 | 2.2 |
| Comparative Example 2 | 0.05 | 53.7 | 20 |

The joining pastes obtained in Examples 1 to 3 contained copper particles having an average primary particle size of 0.06 μm or more and 1.0 μm or less and an crystallite size increase rate from crystallite size D1 (nm) at 150°C to crystallite size D2 (nm) at 250°C of 5% or more. In the joined bodies produced by using such joining pastes obtained in Examples 1 to 3 and heating the coating film formed therefrom at a temperature of 150°C or more and 350°C or less for 45 minutes or less to sinter the copper particles, the fillet portion of the joining layer was less likely to separate from the first joining target member.

**Industrial Applicability**

According to the present invention, it is possible to provide a method for producing a joined body, wherein in the joined body to be obtained, the fillet portion of the joining layer is less likely to separate from the joining target member.

**Claims**

1. A method for producing a joined body, the method comprising:

    forming a coating film between first and second target members to be joined,
    wherein the coating film is formed from a paste containing copper particles, and then
    heating the coating film to sinter the copper particles to form a joining layer;

    wherein

    the copper particles have an average primary particle size of 0.06 μm or more and 1 μm or less, and include copper particles having an increase rate of a crystallite size, (D2 - D1)/D1 × 100, of 5% or more, where D1 represents a crystallite size (nm) at 150°C and D2 represents a crystallite size (nm) at 250°C; and
    the coating film is held at a heating temperature of 150°C or more and 350°C or less for 45 minutes or less to sinter the copper particles.

2. The method for producing a joined body according to claim 1,
    wherein the increase rate, (D2 - D1)/D1 × 100, is 7.5% or more.

3. The method for producing a joined body according to claim 1 or 2,
    wherein the paste contains the copper particles in an amount of 60 mass% or more and 99 mass% or less.

8

(a) Applying

(b) Drying

(c) Placing second joining target member

(d) Joining

Fig. 1

Fig. 2

## INTERNATIONAL SEARCH REPORT

| International application No. |
|---|
| **PCT/JP2023/012388** |

**A. CLASSIFICATION OF SUBJECT MATTER**

*H01L 21/52*(2006.01)i; *B22F 1/00*(2022.01)i; *B22F 7/08*(2006.01)i
FI: H01L21/52 D; B22F1/00 L; B22F7/08 C

According to International Patent Classification (IPC) or to both national classification and IPC

**B. FIELDS SEARCHED**

Minimum documentation searched (classification system followed by classification symbols)

H01L21/52; B22F1/00; B22F7/08

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2019-2054 A (MITSUI MINING AND SMELTING CO., LTD.) 10 January 2019 (2019-01-10)<br>entire text | 1-3 |
| A | JP 2013-87308 A (NIPPON STEEL & SUMIKIN CHEMICAL CO., LTD.) 13 May 2013 (2013-05-13)<br>entire text, all drawings | 1-3 |
| A | JP 2003-141929 A (MITSUI MINING AND SMELTING CO., LTD.) 16 May 2003 (2003-05-16)<br>entire text | 1-3 |
| A | WO 2019/188511 A1 (HARIMA CHEMICALS, INC.) 03 October 2019 (2019-10-03)<br>entire text, all drawings | 1-3 |

☐ Further documents are listed in the continuation of Box C.   ☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **31 May 2023** | **13 June 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2023/012388**

| Patent document cited in search report | | | Publication date (day/month/year) | Patent family member(s) | | | Publication date (day/month/year) |
|---|---|---|---|---|---|---|---|
| JP | 2019-2054 | A | 10 January 2019 | (Family: none) | | | |
| JP | 2013-87308 | A | 13 May 2013 | (Family: none) | | | |
| JP | 2003-141929 | A | 16 May 2003 | (Family: none) | | | |
| WO | 2019/188511 | A1 | 03 October 2019 | EP | 3778069 | A1 | |
| | | | | entire text, all drawings | | | |
| | | | | TW | 201942372 | A | |
| | | | | JP | 2022-46765 | A | |

Form PCT/ISA/210 (patent family annex) (January 2015)

**EP 4 503 103 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019002054 A